# EUROPEAN PATENT SPECIFICATION

(11) **EP 3 623 663 B1**
(45) Date of publication and mention of the grant of the patent: **03.11.2021**
(21) Application number: 19195454.4
(22) Date of filing: 04.09.2019
(51) Int. Cl.: F16H 61/00, F16H 61/30

(54) **ACTUATOR UNIT FOR A VEHICLE GEARBOX**
AKTUATOREINHEIT FÜR EIN FAHRZEUGGETRIEBE
UNITÉ D'ACTIONNEUR POUR UNE BOÎTE DE VITESSES DE VÉHICULE

(30) Priority: 12.09.2018 DE 102018122301
(43) Date of publication of application: 18.03.2020
(73) Proprietor: FTE automotive GmbH, 96106 Ebern (DE)
(72) Inventor: VOIGT, Christian, 96106 Ebern (DE)
(74) Representative: Valeo Powertrain Systems

(56) References cited:
- EP-A1- 3 109 951
- DE-U1- 29 721 908
- US-A- 5 611 372
- US-A1- 2007 024 411
- US-A1- 2017 204 966

## Description

The invention relates to an actuator unit for a vehicle gearbox.

The actuator unit contains a plurality of actuators with which a component to be actuated (for example a gear selector rod provided with gear selector fork) can in each case be adjusted. Gear changing of the vehicle gearbox can thereby be undertaken in the desired manner (in the above example, a gear can be engaged or disengaged).

The actuators can be small hydraulic cylinders with which a hydraulic pressure can be converted into a lifting movement. A piston is arranged here in the actuator and can be adjusted within a cylinder housing of the actuator.

The actuators are arranged on a baseplate, on which other components, for example a temperature sensor, can also be arranged. Such a construction is known from WO 2008/006637 A1. An actuator unit provided with a flexible printed circuit board is known from US 2017/0204966 A1.

It is the object of the invention to provide an actuator unit which can be fitted with a temperature sensor with little effort, in particular in an automated manner.

To achieve this object, according to the invention an actuator unit is provided which has a baseplate, a plurality of actuators which are mounted on the baseplate, a plurality of sensors which are assigned at least to some of the actuators, a flexible printed circuit board on which the sensors are mounted, and a temperature sensor which is arranged on the flexible printed circuit board. The invention is based on the basic concept of not mounting the temperature sensor as a separate component on the baseplate, but rather of integrating same into a component which is in any case mounted on the baseplate, namely into the flexible printed circuit board which bears the sensors which provide a position signal about the position of the actuators. The outlay for the installation of the temperature sensor, a further plug and the plugging-in operation is thereby dispensed with.

The temperature sensor can be an NTC resistor which can be mounted on the flexible printed circuit board with little outlay.

According to one refinement of the invention, there is a plug, the contacts of which are electrically conductively connected to strip conductors of the flexible printed circuit board. Said plug can be inserted with little outlay into a receptacle in the baseplate and fastened there, for example with a fastening clip, which is latched into a groove in the plug body.

According to a preferred embodiment, it is provided that the flexible printed circuit board is provided with a plurality of latching elements with which it is fixed on the baseplate. With the latching elements, the flexible printed circuit board, and therefore the sensors mounted thereon, can be preassembled on the baseplate. The baseplate serves here as a type of installation support on which the sensors are mounted first, followed by the actuators.

According to an embodiment of the invention, it is provided that the latching elements are of plate-like design and each have a plurality of latching pins. By this means, the latching element has comparatively large dimensions, and therefore it can easily be grafted and mounted by an installation robot.

Each latching element here preferably has an area which is at least twice the area of the associated sensor. However, the latching element may also be significantly larger than the sensor, for example may have ten times the area. It is likewise preferred for the latching element to protrude laterally over the flexible printed circuit board or to at least end flush with the printed circuit board so that it can be grasped by an installation robot without there being the risk of the flexible printed circuit board being damaged.

The latching pins can have elastically deformable lugs which can be pressed into suitable bores or openings in the baseplate and remain there by frictional locking.

A latching element is preferably in each case arranged below a sensor, and therefore the latching element forms a stable base for the sensor which is thereby mounted in a precise position.

The latching elements can be laminated or adhesively bonded onto the flexible printed circuit board such that they form a preassembled unit with the flexible printed circuit board.

The invention is described below with reference to an embodiment and is illustrated in the attached drawings. In the drawings:
Figure 1 shows a perspective view of an actuator unit according to the invention;
Figure 2 shows the actuator unit from Figure 1, wherein some of the actuators have been removed so that the flexible printed circuit board can be seen better;
Figure 3 shows a schematic section of an actuator with an associated sensor;
Figure 4 shows a perspective view of the installation of the flexible printed circuit board on the baseplate;
Figure 5 shows a perspective view of an actuator with an associated seal and sensor;
Figure 6 shows a perspective bottom view of the actuator from Figure 5 with an associated seal;
Figure 7 shows a schematic sectional view of the actuator with a preassembled seal before the installation on the baseplate;
Figure 8 shows a schematic sectional view of the actuator mounted on the baseplate;

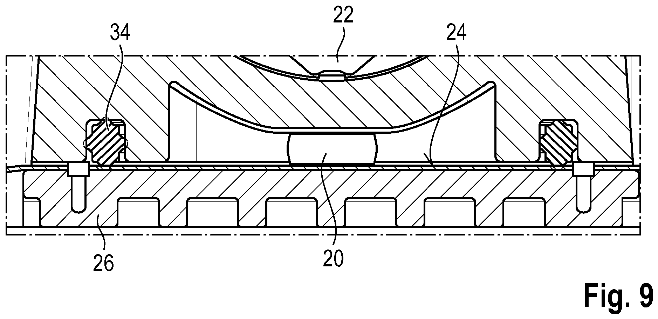

Figure 9 shows the actuator from Figure 8 in another sectional plane;
Figure 10 shows a perspective view of a plug preassembled on the baseplate before the fastening clip is attached;
Figure 11 shows the plug from Figure 10 in a top view;
Figure 12 shows a view corresponding to that of Figure 10 with the fastening clip attached;
Figure 13 shows a section level with the groove through the plug with the fastening clip attached to the plug;
Figure 14 shows, in a view similar to Figure 1, part of a baseplate with actuators, flexible printed circuit board and a temperature sensor mounted thereon;
Figure 15 shows the part facing away from the plug of a variant embodiment of a flexible printed circuit board on which a temperature sensor is mounted; and

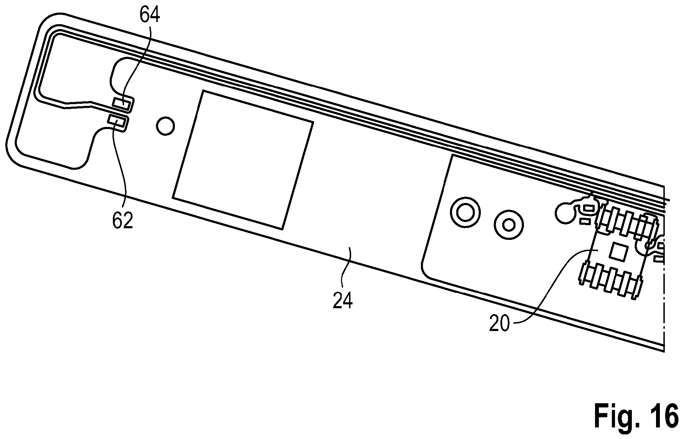

Figure 16 shows, on an enlarged scale, the section of a flexible printed circuit board that is provided for supporting the temperature sensor.

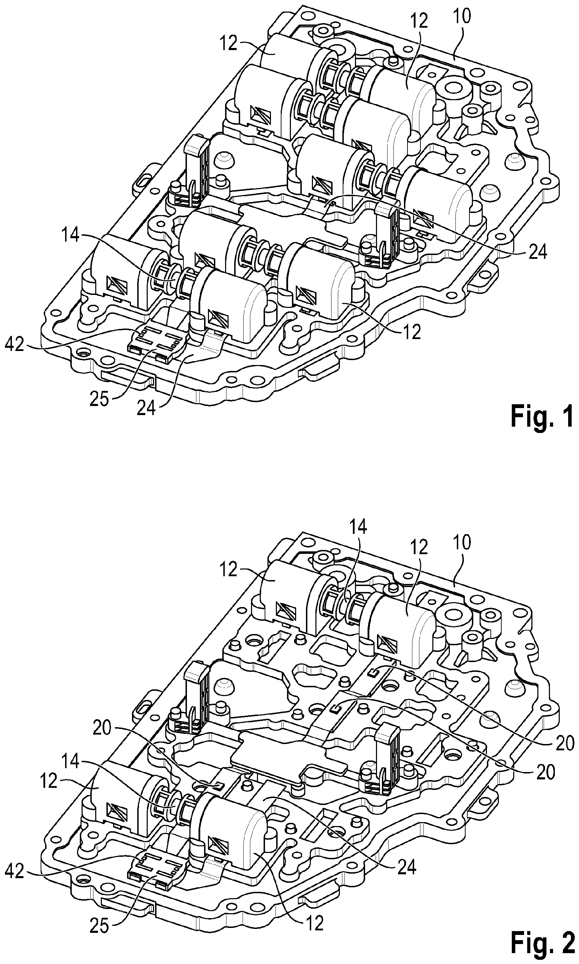

Figures 1 and 2 show an example of an actuator unit which is provided for adjusting a component to be actuated of a manual gearbox. This can be, for example, a gear selector fork.

The actuator unit has a baseplate 10 on which a plurality of actuators 12 are arranged. The latter are arranged here opposite one another in pairs and act on a common actuator rod 14.

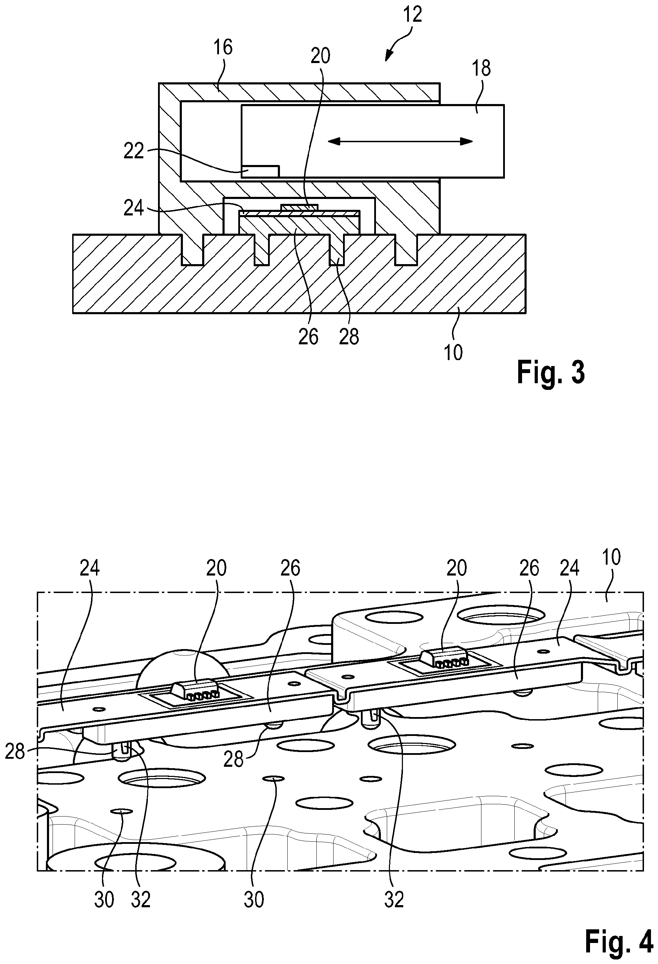

Each actuator is a hydraulic cylinder with a cylinder housing 16 (also see Figure 3) in which a piston 18 is arranged. The piston is connected to the actuator rod 14.

The actuator rod 14 can be actuated in the desired manner by application of a hydraulic pressure on one side of the piston 18.

So that information about the position of the piston 18 and therefore of the actuator rod 14 is available to an electronic control system (not shown here), a sensor 20 is provided which is arranged directly adjacent to the cylinder housing 16. The sensor 20 can be a Hall sensor which responds to the magnetic field of a magnet 22 mounted on the piston 18.

Since, in the exemplary embodiment shown, two actuators are always connected to each other via a common actuator rod 14, it is sufficient to provide a sensor 20 on one of the two actuators 12 of a pair.

The sensors 20 are all arranged on a flexible printed circuit board 24 which extends along the baseplate 10.

In the exemplary embodiment shown, the flexible printed circuit board 24 extends with a main arm over virtually the entire baseplate 10, and therefore it bears four sensors for four pairs of actuators 12, and a shorter secondary arm is provided which bears a sensor 20 for the fifth actuator pair.

For the electrical connection of the flexible printed circuit board 24 and therefore of the sensors 20, a plug 25 is provided which is arranged here in the vicinity of a side edge of the baseplate 10. The two arms of the flexible printed circuit board 24 emerge from the plug 25.

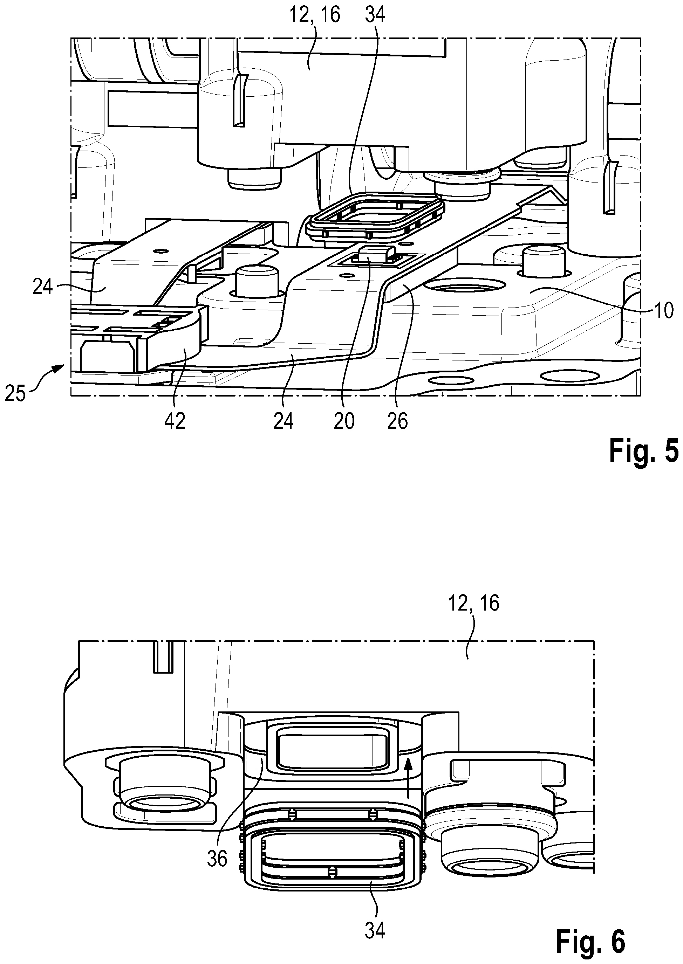

Each sensor 20 is assigned a latching element 26 which here is in the form of a rectangular plate (also see Figures 4 and 5).

Each latching element 26 is arranged here below the corresponding sensor 20. It is adhesively bonded or laminated onto the flexible printed circuit board 24.

On the side facing away from the flexible printed circuit board 24, each latching element 26 is provided with a plurality of latching pins 28 which are provided for engaging in associated openings 30 in the baseplate 10.

In order to improve the frictional locking of the latching pins 28 in the openings 30, each latching pin 28 has at least one and preferably more than one elastically deformable lug 32.

As can be seen in Figures 5 and 6, an annular seal 34 is provided for each sensor 20, said seal providing a seal around a sensor 20 between the cylinder housing 16 of the actuator 12 and the flexible printed circuit board 24. The seal 34 is composed of a suitable elastically deformable material and is accommodated in a groove 36 which is formed on that side of the cylinder housing 16 of the actuator 12 which faces the printed circuit board 24.

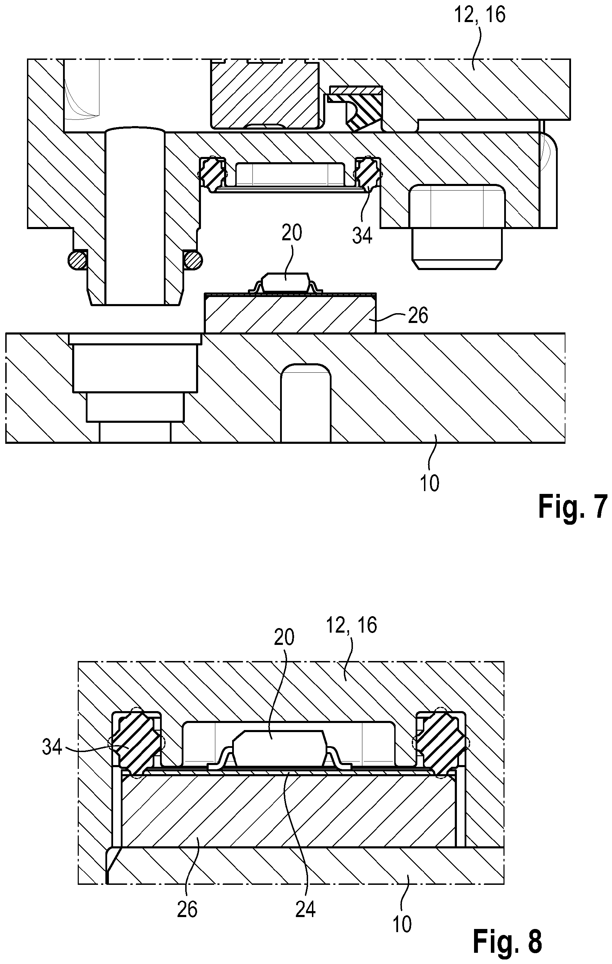

Figure 7 shows an intermediate step during the installation of the actuator unit. The plate-like latching element 26 is already preassembled together with the sensor 20 on the baseplate. Accordingly, the entire flexible printed circuit board 24 is fixed on the baseplate 10. Subsequently, the actuator 12 on which the seal 34 is already preassembled is mounted on the baseplate 10.

The actuator 12 mounted above the sensor 20 can be seen in Figure 8. The latching element 26 ensures here that the sensor 20 is in a precise position, predetermined with low tolerances, relative to the actuator 12. At the same time, the seal 34 provides a reliable seal between the cylinder housing 16 of the actuator 12 and the flexible printed circuit board 24 since it is held with pretension in the installation direction.

The actuator 12 reliably holds the sensor in its position with the pretension of the seal 34 and also prevents the sensor being detached from the baseplate.

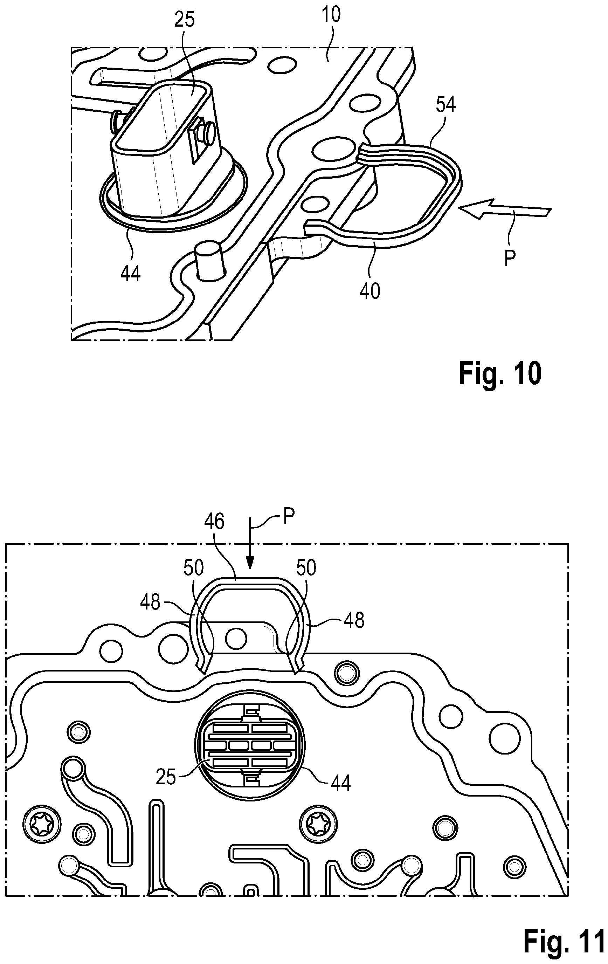

The plug 25 (also see Figures 10 to 12) is fastened to the baseplate 10 by said plug being provided on one side (the side of the flexible printed circuit board 24) with a contact surface and being locked on the opposite side by means of a fastening clip 40.

The contact surface is that side of the contact plate 42, which is visible in Figures 1, 2 and 5, which faces the baseplate 10.

On the opposite side, the plug 25 is provided with a groove 44 into which the fastening clip 40 can be latched. The fastening clip 40 has a generally C-shaped configuration with a central web 46 and two side webs 48.

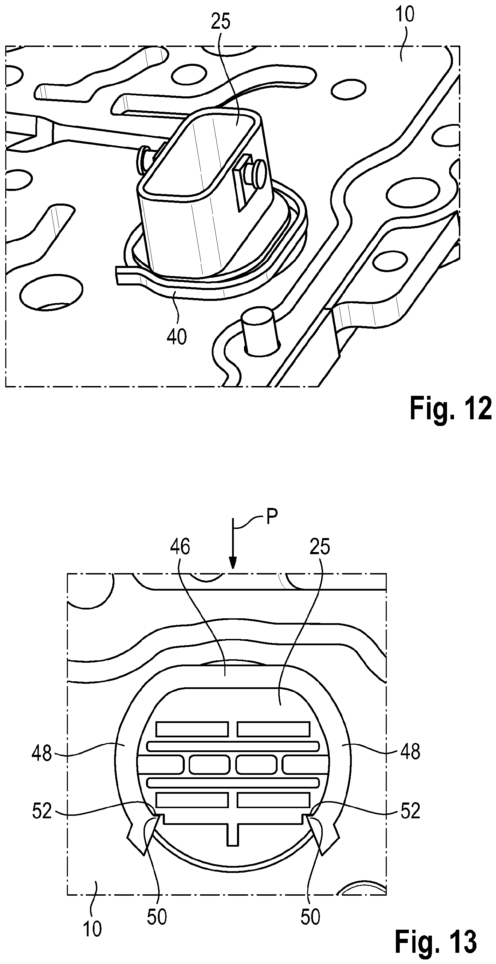

At the free end of each side web 48, a latching lug 50 is provided which, when the fastening clip is fitted, lies against a latching surface 52 which is provided within the groove 44 (see in particular Figure 13). The latching surfaces 53 and those surfaces of the latching lugs 50 which interact therewith are oriented perpendicularly to the direction P in which the fastening clip 40 is pushed into the groove 44 of the plug 25.

The elasticity of the fastening clip 40 is selected in such a manner that it can be pushed into the groove 44 of the plug 25 in the radial direction with respect to the plug without a special tool for widening the two side limbs 48 being required for this purpose. The fastening clip 40 can therefore be mounted by simple pushing in the radial direction. It then comes to lie in the groove 44 in such a manner that it is supported on the baseplate 10, and therefore the plug 25 cannot be removed from the opening in the baseplate into which it has been inserted.

In order to obtain particularly high shearing forces, the fastening clip 40 has an encircling raised edge 54 which comes to lie outside the groove 44 when the fastening clip 40 is mounted.

The baseplate 10 is also provided with a temperature sensor 60 in order to obtain a signal about the oil temperature. The temperature sensor is mounted here directly on the flexible printed circuit board 24, and therefore no separate component has to be mounted on the baseplate 10 and also no separate component has to be electrically contacted.

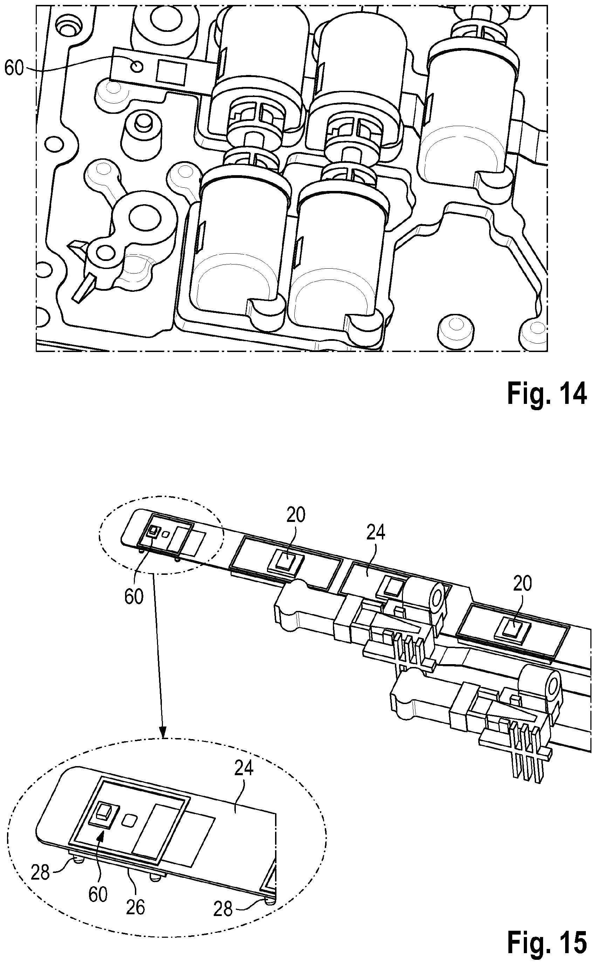

In the embodiment shown in Figure 14, the temperature sensor 60 is arranged at the free end of the flexible printed circuit board 24, i.e. at the end facing away from the plug 25.

However, the temperature sensor 60 may also be arranged at other locations of the flexible printed circuit board 24 depending on the structural circumstances. In principle, any location is suitable on which there is sufficient space on the printed circuit board 24 and which is exposed during operation to the gearbox oil, the temperature of which is intended to be measured.

Below the temperature sensor 60, a latching element 26 having latching pins 28 is mounted on the flexible printed circuit board 24 in the same manner as in the case of the sensors 20. The latching element makes it possible to reliably fasten the flexible printed circuit board 24 in the region of the temperature sensor 60, and therefore the temperature sensor 60, to the baseplate 10.

It can be seen in Figure 15 that the temperature sensor 60 is arranged in the vicinity of other components on the flexible printed circuit board, in particular in the vicinity of the sensors 20 with which the position of the actuators is sensed.

The temperature sensor 60 is in particular an NTC resistor which is mounted on two contact surfaces 62, 64 which are connected to the plug 25 via strip conductors 66, 68 of the flexible printed circuit board 24.

## Claims

1. Actuator unit for a vehicle gearbox, with a baseplate (10), a plurality of actuators (12) which are mounted on the baseplate, a plurality of sensors (20) which are assigned at least to some of the actuators (12), a flexible printed circuit board (24) on which the sensors (20) are mounted, **characterized in that** a temperature sensor (60) is arranged on the flexible printed circuit board (24) and **in that** the temperature sensor (60) is arranged in the vicinity of the sensors (20) with which the position of the actuators is sensed.

2. Actuator unit according to Claim 1, **characterized in that** the temperature sensor (60) is an NTC resistor.

3. Actuator unit according to Claim 1 or Claim 2, **characterized in that** there is a plug (25), the contacts of which are electrically conductively connected to strip conductors of the flexible printed circuit board (20).

4. Actuator unit according to Claim 3, **characterized in that** the plug (25) has a groove (44) into which a fastening clip (40) is latched.

5. Actuator unit according to one of the preceding claims, **characterized in that** the flexible printed circuit board (24) is provided with a plurality of latching elements (26) with which it is fixed on the baseplate (10).

6. Actuator unit according to Claim 5, **characterized in that** the latching elements (26) are of plate-like design and each have a plurality of latching pins (28).

7. Actuator unit according to Claim 6, **characterized in that** the latching pins (28) have elastically deformable lugs (32).

8. Actuator unit according to one of the preceding claims, **characterized in that** each latching element (26) has an area which is at least twice the area of the associated sensor (20).

9. Actuator unit according to one of the preceding claims, **characterized in that** a latching element (26) is in each case arranged below a sensor (20).

10. Actuator unit according to one of the preceding claims, **characterized in that** the latching elements (26) are laminated or adhesively bonded onto the flexible printed circuit board (24).

## Patentansprüche

1. Aktuatoreinheit für ein Fahrzeuggetriebe, mit einer Grundplatte (10), einer Vielzahl von Aktuatoren (12), die auf der Grundplatte montiert sind, einer Vielzahl von Sensoren (20), die zumindest einem Teil der Aktuatoren (12) zugeordnet sind, einer flexiblen Leiterplatte (24), auf der die Sensoren (20) montiert sind, **dadurch gekennzeichnet, dass** auf der flexiblen Leiterplatte (24) ein Temperatursensor (60) angeordnet ist und dass der Temperatursensor (60) in der Nähe der Sensoren (20) angeordnet ist, mit denen die Position der Aktuatoren erfasst wird.

2. Aktuatoreinheit nach Anspruch 1, **dadurch gekennzeichnet, dass** der Temperatursensor (60) ein NTC-Widerstand ist.

3. Aktuatoreinheit nach Anspruch 1 oder Anspruch 2, **dadurch gekennzeichnet, dass** ein Stecker (25) vorhanden ist, dessen Kontakte mit Leiterbahnen der flexiblen Leiterplatte (20) elektrisch leitend verbunden sind.

4. Aktuatoreinheit nach Anspruch 3, **dadurch gekennzeichnet, dass** der Stecker (25) eine Nut (44) aufweist, in die ein Befestigungsclip (40) eingerastet wird.

5. Aktuatoreinheit nach einem der vorhergehenden Ansprüche, **dadurch gekennzeichnet, dass** die flexible Leiterplatte (24) mit einer Vielzahl von Rastelementen (26) bereitgestellt ist, mit denen sie auf der Grundplatte (10) befestigt ist.

6. Aktuatoreinheit nach Anspruch 5, **dadurch gekennzeichnet, dass** die Rastelemente (26) plattenförmig ausgebildet sind und jeweils eine Vielzahl von Raststiften (28) aufweisen.

7. Aktuatoreinheit nach Anspruch 6, **dadurch gekennzeichnet, dass** die Raststifte (28) elastisch verformbare Laschen (32) aufweisen.

8. Aktuatoreinheit nach einem der vorhergehenden Ansprüche, **dadurch gekennzeichnet, dass** jedes Rastelement (26) eine Fläche aufweist, die mindestens doppelt so groß ist wie die Fläche des zugehörigen Sensors (20).

9. Aktuatoreinheit nach einem der vorhergehenden Ansprüche, **dadurch gekennzeichnet, dass** unterhalb eines jeden Sensors (20) ein Rastelement (26) angeordnet ist.

10. Aktuatoreinheit nach einem der vorhergehenden Ansprüche, **dadurch gekennzeichnet, dass** die Rastelemente (26) auf die flexible Leiterplatte (24) laminiert oder geklebt sind.

## Revendications

1. Unité d'actionnement pour une boîte de vitesses de véhicule, avec une plaque de base (10), une pluralité d'actionneurs (12) qui sont montés sur la plaque de base, une pluralité de capteurs (20) qui sont attribués au moins à certains des actionneurs (12), une carte de circuit imprimé flexible (24) sur laquelle les capteurs (20) sont montés, **caractérisée en ce qu'**un capteur de température (60) est agencé sur la carte de circuit imprimé flexible (24) et **en ce que** le capteur de température (60) est agencé dans le voisinage des capteurs (20) avec lesquels la position des actionneurs est détectée.

2. Unité d'actionnement selon la revendication 1, **caractérisée en ce que** le capteur de température (60) est une résistance NTC.

3. Unité d'actionnement selon la revendication 1 ou la revendication 2, **caractérisée en ce qu'**il y a une fiche (25), dont les contacts sont connectés de façon électriquement conductrice à des conducteurs bandes de la carte de circuit imprimé flexible (20).

4. Unité d'actionnement selon la revendication 3, **caractérisée en ce que** la fiche (25) a une rainure (44) dans laquelle une agrafe de fixation (40) est verrouillée.

5. Unité d'actionnement selon l'une des revendications précédentes, **caractérisée en ce que** la carte de circuit imprimé flexible (24) est pourvue d'une pluralité d'éléments de verrouillage (26) avec lesquels elle est fixée sur la plaque de base (10).

6. Unité d'actionnement selon la revendication 5, **caractérisée en ce que** les éléments de verrouillage (26) sont de conception de type plaque et ont chacun une pluralité de goupilles de verrouillage (28).

7. Unité d'actionnement selon la revendication 6, **caractérisée en ce que** les goupilles de verrouillage (28) ont des tenons élastiquement déformables (32).

8. Unité d'actionnement selon l'une des revendications précédentes, **caractérisée en ce que** chaque élément de verrouillage (26) a une superficie qui est au moins deux fois plus grande que la superficie du capteur associé (20).

9. Unité d'actionnement selon l'une des revendications précédentes, **caractérisée en ce qu'**un élément de verrouillage (26) est dans chaque cas agencé en dessous d'un capteur (20).

10. Unité d'actionnement selon l'une des revendications précédentes, **caractérisée en ce que** les éléments de verrouillage (26) sont stratifiés ou liés de façon adhésive sur la carte de circuit imprimé flexible (24).
